# FASCICULE DE BREVET EUROPEEN

(11) **EP 3 799 544 B1**
(45) Date de publication et mention de la délivrance du brevet: **19.07.2023**
(21) Numéro de dépôt: 20197366.6
(22) Date de dépôt: 22.09.2020
(51) Int. Cl.: H05K 5/00

(54) **APPAREILLAGE DE COMMANDE D'UNE INSTALLATION DOMOTIQUE**
STEUERGERÄTE FÜR HAUSTECHNIKANLAGE
DEVICE FOR CONTROLLING A HOME AUTOMATION INSTALLATION

(30) Priorité: 30.09.2019 FR 1910798
(43) Date de publication de la demande: 31.03.2021
(73) Titulaire: HAGER CONTROLS, 67700 Saverne (FR)
(72) Inventeur: MISSLER, Jean-Luc, 57720 OBERGAILBACH (FR); PEYRAS, Thierry, 67290 WIMMENAU (FR)
(74) Mandataire: Cabinet Nuss

(56) Documents cités:
- EP-A1- 1 398 847
- EP-A1- 3 099 148
- WO-A1-2016/128668
- WO-A2-2018/002530
- FR-A1- 2 826 136
- US-B1- 7 938 676

## Description

La présente invention concerne le domaine desappareillagesde commande d'une installation domotique, telsque des horloges digitales, pilotant une ou plusieurs charges lumineuses, chauffages et/ou volets roulants, par exemple. Ce type d'appareillage se présente généralement sous la forme d'un module, destiné à être monté sur un rail d'un tableau électrique. De tels produits modulaires ont une dimension imposée par l'usage, par exemple une largeur de deux modules pour ce type d'horloges, une largeur de module étant environ égale à 18 millimètres.

De telles horloges digitales sont connues de l'art antérieur. De telles horloges digitales connues peuvent comporter des moyens de communication radiofréquence detype Bluetooth ou NFC.

Les longueurs d'antennes utilisées pour les communications radiofréquence sont proportionnelles à l'inverse de la fréquence d'émission-réception (2, 4 GHz pour la communication Bluetooth). De ce fait, l'intégration dans un même appareillage de la possibilité de communiquer avec deux protocoles faisant recours à des bandes de fréquences distinctes requiert donc l'ajout d'une deuxième antenne à l'appareillage de commande.

Cassiquement, une telle antenne est constituée soit d'une piste gravée sur un circuit imprimé, soit d'une tige métallique, par exemple en cuivre, reliée électriquement au circuit imprimé et agencée à l'intérieur d'un boîtier de l'appareillage de commande. Dans ces deux cas, il est nécessaire de prévoir un volume spécifique pour cette antenne additionnelle.

Le document EP1398847 concerne un dispositif d'antenne, un tableau de connexions imprimé, une carte de circuit imprimé, un adaptateur de communication et un équipement électronique portable. Un élément de blindage a une double fonction. En plus de protéger un composant contre les interférences électromagnétiques, il est également utilisé comme élément de masse de l'antenne. Ainsi, la taille globale du dispositif d'antenne peut être réduit ou rester limité.

Le document US7938676B1 concerne une prise électrique dotée d'une antenne configurée pour recevoir des signaux radiofréquence pour permettre la commande sansfil d'une prise électrique et d'un boîtier dans lequel est disposée au moins partiellement ladite antenne. La prise électrique comprend une carte de circuit imprimé conçue pour avoir un plan de masse configuré pour se connecter et pour créer une impédance adaptée à l'antenne.

Le document WO2016/128668A1 concerne un appareil électrique comprenant un boîtier et un circuit électronique permettant de traiter des informations pour contrôler une charge, au moins une antenne plane et un module de comunication de proximité connectée à ladite antenne et relié au circuit électronique.

Le document FR2826136A1 a pour objet un procédé de programmation d'horloge programmable et une clé de programmation pour la mise en oeuvre de ce procédé et intégrant à cet effet un circuit électronique muni d'au moins une mémoire. Il divulgue une horloge programmable à clé se présentant sous la forme d'un boîtier modulaire pourvu d'une ouvertue de réception de la clé de programmation, un écran et un clavier de programmation.

Le document EP3099148A1 a pour objet un appareil électrique d'une installation domestique, ledit appareil comprenant un circuit impriméet un boîtier.

Le document WO2018/002530A2 concerne une carte électronique comprenant un circuit imprimé, un microcontrôleur alimenté à un dispositif d'alimentation et un premier moyen de communication par radio fréquence apte à communiquer dans une première bande de fréquence et un deuxième moyen de communication apte à communiquer dans une deuxième bande de fréquence distincte et/ou disjointe de la première.

La présente invention a pour but de pallier les inconvénients des appareillages de commande connus de l'art antérieur. La présente invention a pour but de proposer un appareillage de commande présentant la possibilité de communiquer par radiofréquence dans deux bandes de fréquences distinctes tout en gardant un volume limité dudit appareillage.

L'appareillage de commande selon l'invention comprend un boîtier et un dispositif de commande agencé dans le boîtier. Le dispositif de commande comporte un circuit imprimé pourvu d'un plan de masse, un premier module électronique, à savoir un module de communication radiofréquence, agencé sur le circuit imprimé et comprenant une sortie d'antenne, un deuxième module électronique agencé sur le circuit imprimé et une armature métallique de blindage du deuxième module électronique. L'armature métallique comporte un premier élément d'armature relié électriquement au plan de masse. Le premier élément d'armature est en outre relié électriquement à la sortie d'antenne.

L'appareillage de commande selon l'invention présente l'avantage de pouvoir intégrer la communication par radiofréquence dans une bande de fréquences additionnelle sans augmenter son volume. Le premier élément d'armature de l'appareillage de commande selon l'invention accomplit donc au moins deux fonctions, c'est-à-dire une fonction de blindage du deuxième module électronique et une fonction d'antenne pour le module de communication radiofréquence.

Selon une caractéristique additionnelle possible, le premier élément d'armature relie mécaniquement le deuxième module électronique au circuit imprimé.

Ainsi, le premier élément d'armature accomplit une fonction additionnelle de fixation du deuxième module électronique au circuit imprimé.

Selon une possibilité, le deuxième module électronique est un module de visualisation, de préférence un écran.

Selon une caractéristique additionnelle possible, l'écran est un écran à cristaux liquides.

Selon une possibilité, l'armature métallique de blindage du deuxième module électronique comporte en outre un deuxième élément d'armature séparé et distant du premier élément d'armature et relié électriquement au plan de masse.

Ces caractéristiques permettent d'améliorer le blindage du deuxième module électronique.

Selon une possibilité, le premier élément d'armature et le deuxième élément d'armature peuvent être agencés de part et d'autre du deuxième module électronique, par exemple sur deux côtés opposés du module de visualisation/de l'écran.

Selon une caractéristique additionnelle possible, le premier élément d'armature et/ou le deuxième élément d'armature est/sont réalisé(s) à partir d'une tôle découpée et pliée.

Ces caractéristiques facilitent la fabrication de l'appareillage de commande.

Selon une possibilité, le premier élément d'armature et/ou le deuxième élément d'armature peuvent être réalisés en cuivre et/ou en laiton.

Selon une caractéristique additionnelle possible, le premier élément d'armature et/ou le deuxième élément d'armature peuvent être fixés au circuit imprimé par soudage.

Selon une possibilité, le deuxième module électronique comprend un support et un composant électronique agencé sur le support. Le composant électronique peut être un composant de visualisation tel qu'une dalle d'affichage à cristaux liquides.

Selon une caractéristique additionnelle possible, le support peut être fabriqué en un matériau isolant, de préférence en un matériau plastique.

Selon une possibilité, le premier élément d'armature et/ou le deuxième élément d'armature est/sont relié(s) mécaniquement au support, de préférence par encliquetage. A cet effet, des dispositifs de clipsage peuvent être prévus sur le support et sur l'élément d'armature respectif.

Selon une caractéristique additionnelle possible, le module de communication radiofréquence est un module de communication domotique, de préférence un module de communication KNX-RF. Le module de communication radiofréquence peut être adapté à l'émission et/ou la réception d'ondes électromagnétiques d'une fréquence d'environ 868 MHz.

Selon une possibilité, le circuit imprimé comporte en outre une piste d'antenne, reliant électriquement la sortie d'antenne au premier élément d'armature.

L'invention sera mieux comprise grâce à la description ci-après, qui se rapporte à un mode de réalisation préféré, donné à titre d'exemple non limitatif, et expliqué avec référence aux dessins schématiques annexés, dans lesquels :

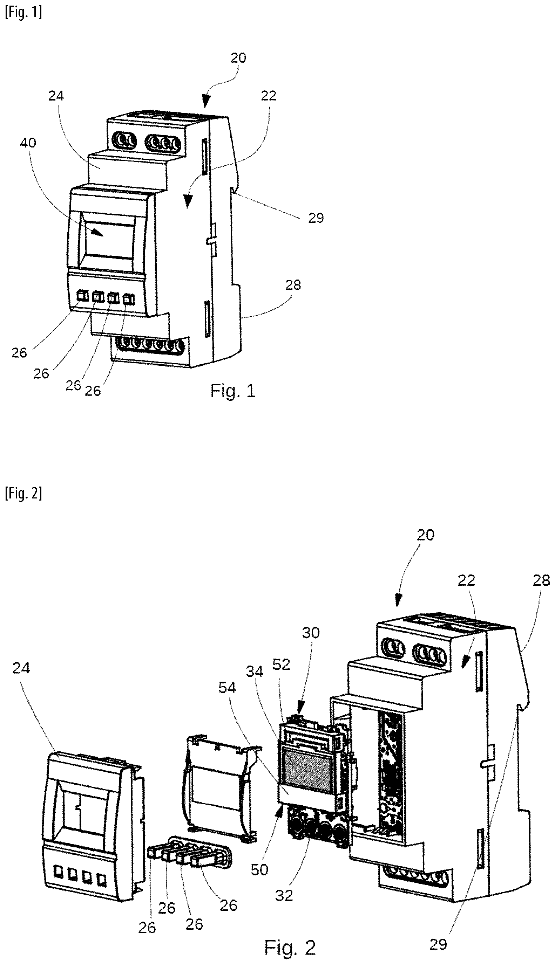

[Fig. 1] représente une vue en perspective d'un appareillage de commande selon l'invention dans un mode de réalisation ;
[Fig. 2] représente une vue éclatée de l'appareillage de commande représenté dans la Fig. 1 ;

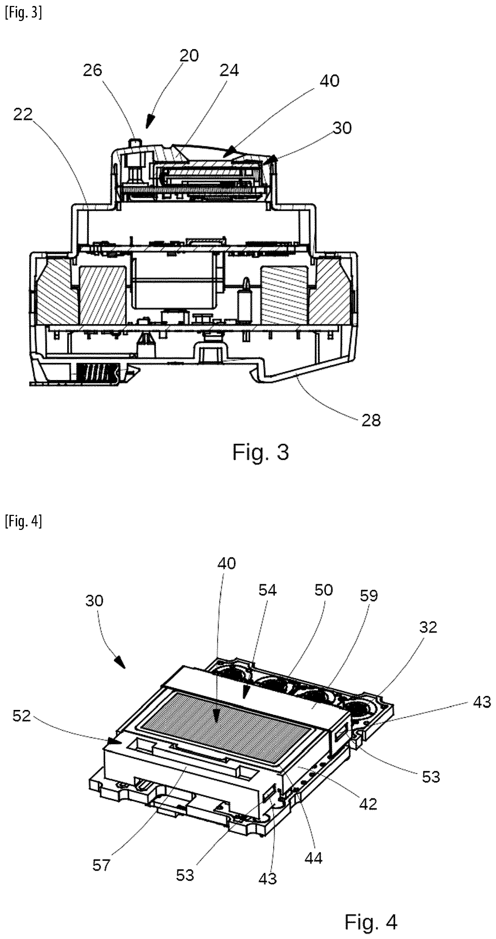

[Fig. 3] représente une vue en coupe de l'appareillage de commande représenté dans la Fig. 1 ;

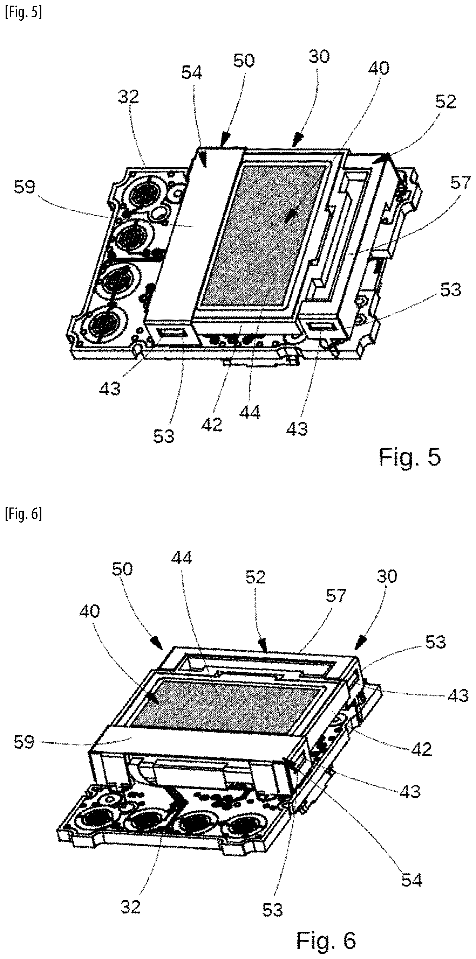

[Fig. 4], [Fig. 5] et [Fig. 6] représentent chacune une vue en perspective d'un dispositif de commande de l'appareillage de commande représenté dans la Fig. 1 ;
[Fig. 7] et [Fig. 8] représentent chacune une vue éclatée d'un dispositif de commande de l'appareillage de commande représenté dans la Fig. 1.

La présente demande a pour objet un appareillage de commande 20 d'une installation domotique. L'appareillage de commande 20 comprend un boîtier 22 et un dispositif de commande 30 agencé dans le boîtier 22. Le dispositif de commande 30 comporte un circuit imprimé 32 pourvu d'un plan de masse, un premier module électronique, à savoir un module de communication radiofréquence 34, agencé sur le circuit imprimé 32 et comprenant une sortie d'antenne 35, un deuxième module électronique 40 agencé sur le circuit imprimé 32 et une armature métallique 50 de blindage du deuxième module électronique 40. L'armature métallique 50 comporte un premier élément d'armature 52 relié électriquement au plan de masse. Le premier élément d'armature 52 est en outre relié électriquement à la sortie d'antenne 35.

Le premier élément d'armature 52 étant à la fois relié à la sortie d'antenne 35 et au plan de masse du circuit imprimé 32, il peut à la fois faire office de blindage du module électronique 40 et former une partie de l'antenne permettant d'émettre et de recevoir les signaux radiofréquence envoyés par et/ou destinés au module de communication radiofréquence 34.

L'appareillage de commande 20 de la présente demande peut être une horloge digitale pilotant une ou plusieurs charges lumineuses, un chauffage et/ des volets roulants, par exemple. À cet effet, l'appareil de commande 20 peut comprendre un bornier de connexion au secteur ainsi que, pour chaque dispositif destiné à être piloté par l'appareillage de commande 20, un bornier de connexion au dispositif, c'est-à-dire aux charges lumineuses, au chauffage, aux volets roulants, par exemple.

Le boîtier 22 de l'appareillage de commande 20 peut comporter une face frontale 24 de laquelle peuvent faire saillie un ou plusieurs boutons de commande 26 permettant de commander et/ou programmer l'appareillage de commande 20. Le boîtier 22 de l'appareillage de commande 20 peut comporter dans la face arrière 28 opposée à la face frontale 24 une encoche 29 permettant la fixation de l'appareillage de commande 20 à un rail de fixation, tel qu'un rail de fixation communément employé dans des tableaux électriques. L'appareillage de commande 20 selon le mode de réalisation se présente sous une forme modulaire et occupe une largeur dite de deux modules, ce qui correspond à environ 36 mm de largeur, dans le tableau électrique dans lequel il est installé.

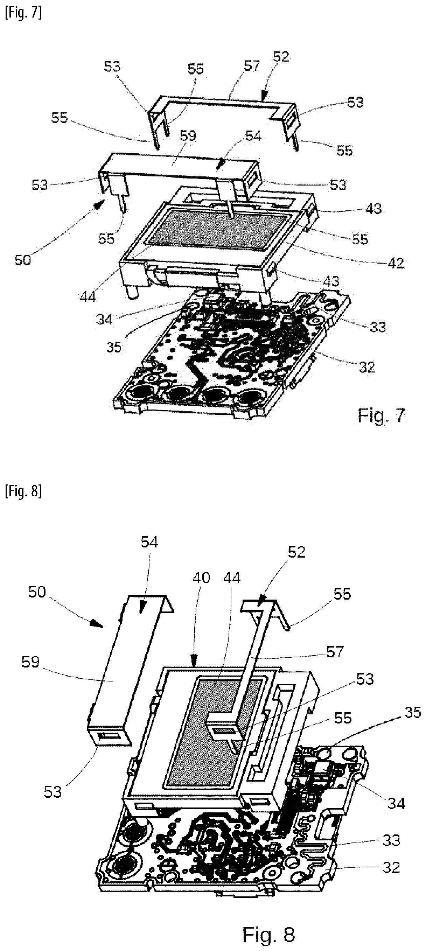

Le premier élément d'armature 52 peut relier mécaniquement le deuxième module électronique 40 au circuit imprimé 32. Le premier élément d'armature 52 peut comprendre une partie centrale de liaison 57 se présentant sous une forme essentiellement en U, tel que le divulgue par exemple la figure 8.

Le deuxième module électronique 40 peut être un module de visualisation, de préférence un écran permettant d'afficher des informations à un utilisateur. Le deuxième module électronique 40 peut en outre de préférence être un écran à cristaux liquides.

La face frontale 24 du boîtier 22 peut être pourvue d'une fenêtre à travers laquelle le deuxième module électronique 40 est visible à un utilisateur.

L'armature métallique 50 de blindage du deuxième module électronique peut en outre comporter un deuxième élément d'armature 54 séparé et distant du premier élément d'armature 52 et relié électriquement au plan de masse. Le premier élément d'armature 52 et le deuxième élément d'armature 54 peuvent ainsi constituer une armature permettant de protéger le deuxième module électronique 40 contre des perturbations électromagnétiques extérieures. Le blindage constitué par l'armature métallique 50 est ainsi séparé en au moins deux parties distinctes, chacune reliée électriquement au plan de masse.

Le deuxième élément d'armature 54 peut également comporter une partie centrale de liaison 59. Le deuxième élément d'armature 54 peut se distinguer du premier élément d'armature 52 essentiellement par la forme de sa partie centrale de liaison 59. La partie centrale de liaison 59 du deuxième élément d'armature 54 peut se présenter sous une forme rectangulaire.

Les parties centrales de liaison 57, 59 respectivement du premier élément d'armature 52 et du deuxième élément d'armature 54 peuvent être positionnées entre une paroi du boîtier 22, de préférence la paroi frontale 24 du boîtier 22, et le deuxième module électronique 40. Les parties centrales de liaison 57, 59, en particulier la partie centrale de liaison 57 du premier élément d'armature 52, peut/peuvent être positionnée(s) à proximité du boîtier 22 et en particulier à proximité de la paroi frontale 24 du boîtier 22. La distance entre la paroi frontale 24 du boîtier 22 peut valoir environ 6 millimètres. Il est ainsi possible de rapprocher la partie centrale de liaison 57 du premier élément d'armature 52 faisant office d'antenne du module de communication radiofréquence 34 de l'extérieur du boîtier 22, afin d'augmenter les performances radio du module de communication radiofréquence 34.

Le premier élément d'armature 52 et/ou le deuxième élément d'armature 54 peut/peuvent être réalisé(s) à partir d'une tôle découpée et pliée.

Le deuxième module électronique 40 peut comprendre un support 42 et un composant électronique 44 agencé sur le support 42.

Le premier élément d'armature 52 et/ou le deuxième élément d'armature 54 peut/peuvent être relié(s) mécaniquement au support 42, de préférence par encliquetage. À cet effet, le premier élément d'armature 52 et/ou le deuxième élément d'armature 54 peut/peuvent comporter au moins une échancrure 53, dans laquelle peut venir se loger un ergot 43 du deuxième module électronique 40 pour fixer le premier élément d'armature 52 au deuxième module électronique 40 par conjugaison de forme. De façon analogue, le deuxième élément d'armature 54 peut également comporter au moins une échancrure 53, dans laquelle peut venir se loger un ergot 43 du deuxième module électronique 40 pour fixer le deuxième élément d'armature 54 au module électronique 40 par conjugaison de forme. L'ergot 43 peut par exemple être formé dans le support 42. L'échancrure 53 peut se présenter sous la forme d'une fenêtre rectangulaire formée dans le premier élément d'armature 52 et/ou le deuxième élément d'armature 54.

Le premier élément d'armature 52 et/ou le deuxième élément d'armature 54 peut/peuvent chacun comprendre au moins une languette 55 permettant la fixation mécanique au circuit imprimé 32. Par le biais de ladite languette 55, le premier élément d'armature 52 et/ou le deuxième élément d'armature 54 peut/peuvent être lié(s) électriquement au plan de masse. En outre, le premier élément d'armature 52 peut être relié électriquement à la sortie d'antenne par le biais de ladite languette 55.

Le module de communication radiofréquence 34 peut être un module de communication domotique, de préférence un module de communication KNX-RF. Un tel module de communication KNX-R F permet l'échange de données par radiofréquence selon un protocole de communication KNX.

Le circuit imprimé 32 peut en outre comporter une piste antenne 33, reliant électriquement la sortie d'antenne 35 au premier élément d'armature 52. Ainsi, l'antenne du module de communication radiofréquence 34 est constituée par l'ensemble formé par la piste d'antenne 33 et le premier élément d'armature 52. La longueur de l'antenne constituée par l'ensemble formé par la piste d'antenne 33 et le premier élément d'armature 52 peut être choisie en fonction de la longueur d'onde/de la fréquence employée pour la communication par radiofréquence. En général, les longueurs d'antenne utilisées pour les communications radiofréquence sont proportionnelles à l'inverse de la fréquence d'émission-réception. Pour le protocole de communication KNX, la fréquence utilisée peut être par exemple de l'ordre de 868 MHz. Pour le protocole de communication Bluetooth, la fréquence utilisée est souvent de l'ordre de 2,4 GHz.

L'appareillage de commande 20 selon la présente demande permet d'optimiser l'encombrement et de réduire les coûts de production en intégrant jusqu'à trois fonctions dans l'armature 50, c'est-à-dire la fonction de fixer le deuxième module électronique 40 au circuit imprimé 32, la fonction d'antenne du module de communication radiofréquence 34 et la fonction de blindage du deuxième module électronique 40.

## Revendications

1. Appareillage de commande d'une installation domotique, comprenant un boîtier (22) et un dispositif de commande (30) agencé dans le boîtier (22), le dispositif de commande (30) comportant un circuit imprimé (32) pourvu d'un plan de masse, un premier module électronique, à savoir un module de communication radiofréquence (34), agencé sur le circuit imprimé (32) et comprenant une sortie d'antenne (35), un deuxième module électronique (40) agencé sur le circuit imprimé (32) et une armature métallique (50) de blindage du deuxième module électronique (40), l'armature métallique (50) comportant un premier élément d'armature (52) relié électriquement au plan de masse, **caractérisé en ce que** le premier élément d'armature (52) est en outre relié électriquement à la sortie d'antenne (35).

2. Appareillage de commande selon la revendication 1, **caractérisé en ce que** le premier élément d'armature (52) relie mécaniquement le deuxième module électronique (40) au circuit imprimé (32).

3. Appareillage de commande selon l'une quelconque des revendications 1 ou 2, **caractérisé en ce que** le deuxième module électronique (40) est un module de visualisation, de préférence un écran.

4. Appareillage de commande selon l'une quelconque des revendications 1 à 3, **caractérisé en ce que** l'armature métallique (50) de blindage du deuxième module électronique comporte en outre un deuxième élément d'armature (54) séparé et distant du premier élément d'armature (52) et relié électriquement au plan de masse.

5. Appareillage de commande selon l'une quelconque des revendications 1 à 4, **caractérisé en ce que** le premier élément d'armature (52) et/ou le deuxième élément d'armature (54) est/sont réalisé(s) à partir d'une tôle découpée et pliée.

6. Appareillage de commande selon l'une quelconque des revendications 1 à 5, **caractérisé en ce que** le deuxième module électronique (40) comprend un support (42) et un composant électronique (44) agencé sur le support (42).

7. Appareillage de commande selon la revendication 6, **caractérisé en ce que** le premier élément d'armature (52) et/ou le deuxième élément d'armature (54) est/sont relié(s) mécaniquement au support (42), de préférence par encliquetage.

8. Appareillage de commande selon l'une quelconque des revendications 1 à 7, **caractérisé en ce que** le module de communication radiofréquence (34) est un module de communication domotique, de préférence un module de communication KNX-RF.

9. Appareillage de commande selon l'une quelconque des revendications 1 à 8, **caractérisé en ce que** le circuit imprimé (32) comporte en outre une piste antenne (33), reliant électriquement la sortie d'antenne (35) au premier élément d'armature (52).

## Patentansprüche

1. Steuergerät einer Haustechnikanlage, das ein Gehäuse (22) und eine in dem Gehäuse (22) eingerichtete Steuervorrichtung (30) beinhaltet, wobei die Steuervorrichtung (30) Folgendes umfasst: eine Leiterplatte (32), die über eine Erdungsebene verfügt, ein erstes elektronisches Modul, genauer gesagt ein Funkfrequenzkommunikationsmodul (34), das auf der Leiterplatte (32) eingerichtet ist und einen Antennenausgang (35) beinhaltet, ein zweites elektronisches Modul (40), das auf der Leiterplatte (32) eingerichtet ist, und einen Metallrahmen (50) zur Abschirmung des zweiten elektronischen Moduls (40), wobei der Metallrahmen (50) ein erstes Rahmenelement (52) umfasst, das elektrisch mit der Erdungsebene verbunden ist, **dadurch gekennzeichnet, dass** das erste Rahmenelement (52) ferner elektrisch mit dem Antennenausgang (35) verbunden ist.

2. Steuergerät nach Anspruch 1, **dadurch gekennzeichnet, dass** das erste Rahmenelement (52) das zweite elektronische Modul (40) mechanisch mit der Leiterplatte (32) verbindet.

3. Steuergerät nach einem beliebigen der Ansprüche 1 oder 2, **dadurch gekennzeichnet, dass** das zweite elektronische Modul (40) ein Visualisierungsmodul, vorzugsweise ein Bildschirm, ist.

4. Steuergerät nach einem beliebigen der Ansprüche 1 bis 3, **dadurch gekennzeichnet, dass** der Metallrahmen (50) zur Abschirmung des zweiten elektronischen Moduls ferner ein zweites Rahmenelement (54) umfasst, das von dem ersten Rahmenelement (52) getrennt und beabstandet ist und elektrisch mit der Erdungsebene verbunden ist.

5. Steuergerät nach einem beliebigen der Ansprüche 1 bis 4, **dadurch gekennzeichnet, dass** das erste Rahmenelement (52) und/oder das zweite Rahmenelement (54) aus einem gestanzten und gefalteten Blech hergestellt ist/sind.

6. Steuergerät nach einem beliebigen der Ansprüche 1 bis 5, **dadurch gekennzeichnet, dass** das zweite elektronische Modul (40) einen Träger (42) und eine an dem Träger (42) eingerichtete elektronische Komponente (44) beinhaltet.

7. Steuergerät nach Anspruch 6, **dadurch gekennzeichnet, dass** das erste Rahmenelement (52) und/oder das zweite Rahmenelement (54) mechanisch, vorzugsweise durch Einrasten, mit dem Träger (42) verbunden ist/sind.

8. Steuergerät nach einem beliebigen der Ansprüche 1 bis 7, **dadurch gekennzeichnet, dass** das Funkfrequenzkommunikationsmodul (34) ein Haustechnikkommunikationsmodul, vorzugsweise ein KNX-RF-Kommunikationsmodul, ist.

9. Steuergerät nach einem beliebigen der Ansprüche 1 bis 8, **dadurch gekennzeichnet, dass** die Leiterplatte (32) ferner eine Antennenspur (33) umfasst, die den Antennenausgang (35) elektrisch mit dem ersten Rahmenelement (52) verbindet.

## Claims

1. Control appliance of a home automation installation, comprising a housing (22) and a control device (30) arranged in the housing (22), the control device (30) comprising a printed circuit (32) provided with a ground plane, a first electronic module, namely a radiofrequency communication module (34), arranged on the printed circuit (32) and comprising an antenna output (35), a second electronic module (40) arranged on the printed circuit (32) and a shielding metal plate (50) of the second electronic module (40), the metal plate (50) comprising a first plate element (52) linked electrically to the ground plane, **characterized in that** the first plate element (52) is also linked electrically to the antenna output (35) .

2. Control appliance according to Claim 1, **characterized in that** the first plate element (52) mechanically links the second electronic module (40) to the printed circuit (32).

3. Control appliance according to either one of Claims 1 and 2, **characterized in that** the second electronic module (40) is a display module, preferably a screen.

4. Control appliance according to any one of Claims 1 to 3, **characterized in that** the shielding metal plate (50) of the second electronic module further comprises a second plate element (54) separate and away from the first plate element (52) and linked electrically to the ground plane.

5. Control appliance according to any one of Claims 1 to 4, **characterized in that** the first plate element (52) and/or the second plate element (54) is/are produced from a cut and folded steel sheet.

6. Control appliance according to any one of Claims 1 to 5, **characterized in that** the second electronic module (40) comprises a support (42) and an electronic component (44) arranged on the support (42) .

7. Control appliance according to Claim 6, **characterized in that** the first plate element (52) and/or the second plate element (54) is/are linked mechanically to the support (42), preferably by snap-fitting.

8. Control appliance according to any one of Claims 1 to 7, **characterized in that** the radiofrequency communication module (34) is a home automation communication module, preferably a KNX-RF communication module.

9. Control appliance according to any one of Claims 1 to 8, **characterized in that** the printed circuit (32) further comprises an antenna track (33), electrically linking the antenna output (35) to the first plate element (52).
